# EUROPEAN PATENT APPLICATION

(11) **EP 3 604 610 A1**
(43) Date of publication of application: **05.02.2020**
(21) Application number: 18774832.2
(22) Date of filing: 15.03.2018
(51) Int. Cl.: C23C 14/34, B23K 1/20

(54) **CYLINDRICAL SPUTTERING TARGET PRODUCTION METHOD AND CYLINDRICAL SPUTTERING TARGET**

(30) Priority: 29.03.2017 JP 2017066107
(71) Applicant: Mitsubishi Materials Corporation, Chiyoda-ku Tokyo 100-8117 (JP)
(72) Inventor: OKANO Shin, Sanda-shi Hyogo 669-1339 (JP); NAGASE Toshiyuki, Naka-shi Ibaraki 311-0102 (JP); KATO Shinji, Sanda-shi Hyogo 669-1339 (JP)
(74) Representative: Hoffmann Eitle
(86) International application number: PCT/JP2018/010225
(87) International publication number: WO 2018/180545

(57) **Abstract**

A production method for a cylindrical sputtering target of the invention includes a solder material coating step of forming a solder underlying layer on an inner peripheral surface of a sputtering target material and an outer peripheral surface of a backing tube; a cooling step of cooling the sputtering target material and the backing tube, after the solder material coating step; an oxide removing step of removing the oxide generated on a surface of the solder underlying layer; and a solder bonding step of solder-bonding the sputtering target material and the backing tube to each other.

## Description

### TECHNICAL FIELD

The present invention relates to a production method for a cylindrical sputtering target including a sputtering target material having a cylindrical shape, and a backing tube that is bonded to an inner peripheral side of the sputtering target material through an adhesive layer formed of In or In alloy, and a cylindrical sputtering target.

Priority is claimed on Japanese Patent Application No. 2017-066107, filed on March 29, 2017, the content of which is incorporated herein by reference.

### BACKGROUND ART

As a means for forming a thin film such as a metal film or an oxide film, a sputtering method using a sputtering target is widely used.

As the sputtering target, for example, a flat plate-shaped sputtering target having a circular or rectangular sputtering surface, and a cylindrical sputtering target having a cylindrical sputtering surface have been proposed.

In the flat plate-shaped sputtering target, the utilization ratio of a target material is low as approximately 20% to 30%, and the film formation could not be efficiently performed.

In contrast, in the cylindrical sputtering target, an outer peripheral surface (cylindrical surface) thereof is set to a sputtering surface, and the sputtering is performed while rotating a target. Accordingly, a region to be sputtered along a shaft line direction formed on a part of the target surface moves in a circumferential direction. As a result, an erosion portion widens in a circumferential direction. Therefore, it is advantageous that a utilization ratio of a sputtering target material having a cylindrical shape is high as 60% to 80%, compared to a case of using the flat plate-shaped sputtering target.

In addition, the cylindrical sputtering target is configured to be cooled from an inner peripheral side of a backing tube and a sputtering target material having a cylindrical shape is sputtered while rotating. Accordingly, a temperature increase in the region to be sputtering is prevented, a power density during the sputtering can be increased, and therefore, it is possible to further improve the throughput of the film formation.

Thus, in recent years, the needs for the cylindrical sputtering target tends to increase.

For example, as disclosed in Patent Document 1, the cylindrical sputtering target has a structure in which a sputtering target material having a cylindrical shape formed according to a composition of a thin film to be formed, and a backing tube that is disposed on an inner peripheral side of this sputtering target material holds the sputtering target are bonded to each other through an adhesive layer. In order to cope with a film formation for a large-sized substrate, it is proposed that a length of the target material of the cylindrical target in a shaft line direction is, for example, set to be equal to or greater than 0.5 m which is comparatively longer.

Here, as an adhesive material configuring the adhesive layer interposed between the sputtering target material and the backing tube, a solder material formed of In, In alloy, and the like is used, for example. In order to reduce workability or a strain, in a case of the bonding, a material in which a melting point of the adhesive material configuring the adhesive layer is, for example, a comparatively low melting point as equal to or lower than 300°C is used.

In the cylindrical sputtering target, in a case of bonding the sputtering target material and the backing tube using the adhesive material, wettability with the adhesive material may be deteriorated, and a bonding strength on a bonding interface between the adhesive layer, and the sputtering target material and the backing tube may be insufficient, depending on a material of the sputtering target material or the backing tube.

Therefore, in Patent Document 1, for example, by applying an adhesive material (solder material) in a melted state, while adding ultrasonic vibration to an inner peripheral surface of the sputtering target material and an outer peripheral surface of the backing tube with an ultrasonic iron mounted with a heater, a solder underlying layer is formed and wettability with the adhesive material (solder material) is improved.

In the cylindrical sputtering target, a solder underlying layer is formed on the sputtering target material and the backing tube and temporarily cooled, the sputtering target material and the backing tube are positioned and assembled, and the melted solder material is allowed to flow into a gap between the sputtering target material and the backing tube, to bond the sputtering target material and the backing tube to each other.

### Citation List

### Patent Literature

[Patent Document 1] Japanese Unexamined Patent Application, First Publication No. 2014-037619

### DISCLOSURE OF INVENTION

### Technical Problem

Meanwhile, in recent years, the cost reduction is required in a liquid crystal panel or a solar cell panel, and thus, it is necessary that a power density during the sputtering is further increased to further improve the throughput of the film formation.

Here, in the cylindrical sputtering target, in a case where a bonding strength on a bonding interface between the adhesive layer, and the sputtering target material and the backing tube is not sufficient, the heat of the sputtering target material cannot be efficiently transmitted to the backing tube side.

Therefore, in a case where the sputtering is performed by further increasing a power density during the sputtering to increase a surface temperature of the sputtering target material having a cylindrical shape, the cooling is insufficiently performed, and the adhesive layer configured with a low-melting-point metal such as In may be melted or the sputtering target material may be cracked. Therefore, in the cylindrical sputtering target of the related art, a further increase in power density cannot be realized.

In addition, in order to realize the cost reduction of a liquid crystal panel or a solar cell panel, a length of the cylindrical sputtering target in a shaft line direction is increased in accordance with an increase in size of a substrate to be formed, but a size thereof in a radial direction is not greatly changed. Accordingly, the heat generated during the sputtering cannot be efficiently released to an inner peripheral side of the backing tube, and the temperature of the cylindrical sputtering target is easily increased. Thus, the adhesive layer may be melted or the sputtering target material may be cracked.

The invention is made in consideration of these circumstances and an object thereof is to provide a production method for a cylindrical sputtering target capable of producing a cylindrical sputtering target having excellent bonding strength of a bonding interface between a sputtering target material and an adhesive layer and a bonding interface between the adhesive layer and a backing tube, and excellent heat release properties, and a cylindrical sputtering target.

### Solution to Problem

In order to achieve the object described above, as a result of the intensive studies of the inventors, it is found that, in a case where an oxide is formed thick on a bonding interface between a sputtering target material and an adhesive layer and a bonding interface between the adhesive layer and a backing tube, the bonding strength is decreased, heat transmission from the sputtering target material to the backing tube is inhibited, and the heat release properties are also deteriorated.

It is found that, in a case where an oxide generated on a surface of a solder underlying layer is bonded using an adhesive material (solder material), the oxide formed on the bonding interface between the sputtering target material and the adhesive layer and the bonding interface between the adhesive layer and the backing tube grows to be thick, due to aggregation on the bonding interface between the sputtering target material and the adhesive layer and the bonding interface between the adhesive layer and the backing tube.

The invention is made in view of the knowledge described above, and there is provided a production method for a cylindrical sputtering target of the invention, that includes a sputtering target material having a cylindrical shape, and a backing tube that is bonded to an inner peripheral side of the sputtering target material through an adhesive layer formed of In or In alloy, the method including: a solder material coating step of heating the sputtering target material and the backing tube, and applying a melted solder material formed of In or In alloy to an inner peripheral surface of the sputtering target material and an outer peripheral surface of the backing tube, to form a solder underlying layer; a cooling step of cooling the sputtering target material and the backing tube, after the solder material coating step; an oxide removing step of removing the oxide generated on a surface of the solder underlying layer, after the cooling step; and a solder bonding step of solder-bonding the sputtering target material and the backing tube to each other by using a solder material formed of In or In alloy, after the oxide removing step.

According to the production method for a cylindrical sputtering target of the invention having such a configuration, after forming the solder underlying layer on the inner peripheral surface of the sputtering target and the outer peripheral surface of the backing tube in the solder material coating step, the oxide is generated on the surface of the solder underlying layer, in the cooling step of cooling the sputtering target material and the backing tube.

In the invention, the oxide removing step of removing the oxide generated on a surface of the solder underlying layer is provided after the cooling step, and accordingly, it is possible to prevent aggregation of the oxide generated on the surface of the solder underlying layer on a bonding interface between the sputtering target material and the adhesive layer and a bonding interface between the adhesive layer and the backing tube, and it is possible to prevent formation of the oxide on the bonding interface between the sputtering target material and the adhesive layer and the bonding interface between the adhesive layer and the backing tube to be thick.

Therefore, it is possible to produce a cylindrical sputtering target having excellent bonding strength between the sputtering target material and the adhesive layer and between the adhesive layer and the backing tube and excellent heat release properties.

Here, in the production method for a cylindrical sputtering target of the invention, in the oxide removing step, the oxide generated on the surface of the solder underlying layer may be removed by performing a heating treatment of the sputtering target material and the backing tube on which the solder underlying layer is formed, under a reducing atmosphere.

In this case, by performing the heating treatment under the reducing atmosphere, it is possible to reduce and remove the oxide generated on the surface of the solder underlying layer. In addition, the oxide present on the inner portion of the solder underlying layer, the interface of the solder underlying layer on the sputtering target material side, the interface of the solder underlying layer on the backing tube side, and the like, can be removed by a reduction treatment.

In the production method for a cylindrical sputtering target of the invention, in the oxide removing step, the oxide generated on the surface of the solder underlying layer may be removed by using a chemical solution.

In this case, the oxide generated on the surface of the solder underlying layer can be chemically removed by performing an etching treatment of the surface of the solder underlying layer using a chemical solution.

In the production method for a cylindrical sputtering target of the invention, in the oxide removing step, the oxide generated on the surface of the solder underlying layer may be removed by machining.

In this case, the oxide generated on the surface of the solder underlying layer can be physically removed by machining such as cutting or grinding.

According to the invention, there is provided a cylindrical sputtering target including: a sputtering target material having a cylindrical shape; and a backing tube that is bonded to an inner peripheral side of the sputtering target material through an adhesive layer formed of In or In alloy, in which a maximum thickness of the oxide on a bonding interface between the sputtering target material and the adhesive layer and a bonding interface between the backing tube and the adhesive layer is equal to or smaller than 300 nm.

According to the cylindrical sputtering target of the invention having such a configuration, the maximum thickness of the oxide is suppressed to be equal to or smaller than 300 nm, on the bonding interface between the sputtering target material and the adhesive layer and the bonding interface between the backing tube and the adhesive layer, and accordingly, it is possible to improve a bonding strength between the sputtering target material and the adhesive layer, and between the backing tube and the adhesive layer.

In addition, the sputtering target material and the adhesive layer, and the backing tube and the adhesive layer are reliably bonded to each other, and accordingly, heat generated on the sputtering target material during the sputtering film formation can be efficiently transmitted to the backing tube side, and heat release properties are excellent.

Therefore, during the sputtering film formation, it is possible to prevent occurrence of cracks on the sputtering target material or melting of the adhesive layer and stably perform the sputtering film formation.

Here, in the cylindrical sputtering target of the invention, it is preferable that a length of the oxide having a thickness equal to or more than 150 nm, on the bonding interface between the sputtering target material and the adhesive layer and the bonding interface between the backing tube and the adhesive layer is equal to or less than 1000 nm.

In this case, the length of the oxide having a thickness equal to or more than 150 nm, on the bonding interface between the sputtering target material and the adhesive layer and the bonding interface between the backing tube and the adhesive layer is equal to or less than 1000 nm, and accordingly, it is possible to improve a bonding strength between the sputtering target material and the adhesive layer, and between the backing tube and the adhesive layer, and the heat release properties are excellent.

In addition, in the cylindrical sputtering target of the invention, it is preferable that a strength, in a case where a tensile test of the sputtering target material, the adhesive layer, and the backing tube is performed in a lamination direction, is equal to or greater than 4 MPa.

In this case, the sputtering target material and the adhesive layer, and the backing tube and the adhesive layer are respectively rigidly bonded to each other, and the heat release properties are excellent.

### Advantageous Effects of Invention

As described above, according to the invention, it is possible to provide a production method for a cylindrical sputtering target capable of producing a cylindrical sputtering target having excellent bonding strength on a bonding interface between a sputtering target material and an adhesive layer and a bonding interface between the adhesive layer and a backing tube, and heat release properties, and to provide a cylindrical sputtering target.

### BRIEF DESCRIPTION OF DRAWINGS

FIG. 1 is a schematic explanatory view of a cylindrical sputtering target according to one embodiment of the invention. (a) is a cross-sectional view orthogonal to a direction of a shaft line O, and (b) is a cross-sectional view along the shaft line O.
FIG. 2 is an enlarged explanatory view of a bonding interface between a sputtering target material and an adhesive layer and a bonding interface between a backing tube and the adhesive layer.
FIG. 3A is an explanatory view showing a collecting method of a tensile test piece for measuring a bonding strength of the sputtering target material and the backing tube.
FIG. 3B is another explanatory view showing a collecting method of a tensile test piece for measuring a bonding strength of the sputtering target material and the backing tube.
FIG. 4 is a flowchart showing a production method of a cylindrical sputtering target according to one embodiment of the invention.
FIG. 5 is a flowchart showing a production method of a cylindrical sputtering target according to another embodiment of the invention.
FIG. 6 is images showing observation results of a bonding interface between a sputtering target material and an adhesive layer of Present Invention Example 2.
FIG. 7 is images showing observation results of a bonding interface between a sputtering target material and an adhesive layer of Comparative Example 1.

### BEST MODE FOR CARRYING OUT THE INVENTION

Hereinafter, a production method of a cylindrical sputtering target and a cylindrical sputtering target according to embodiments of the invention will be described with reference to accompanying drawings.

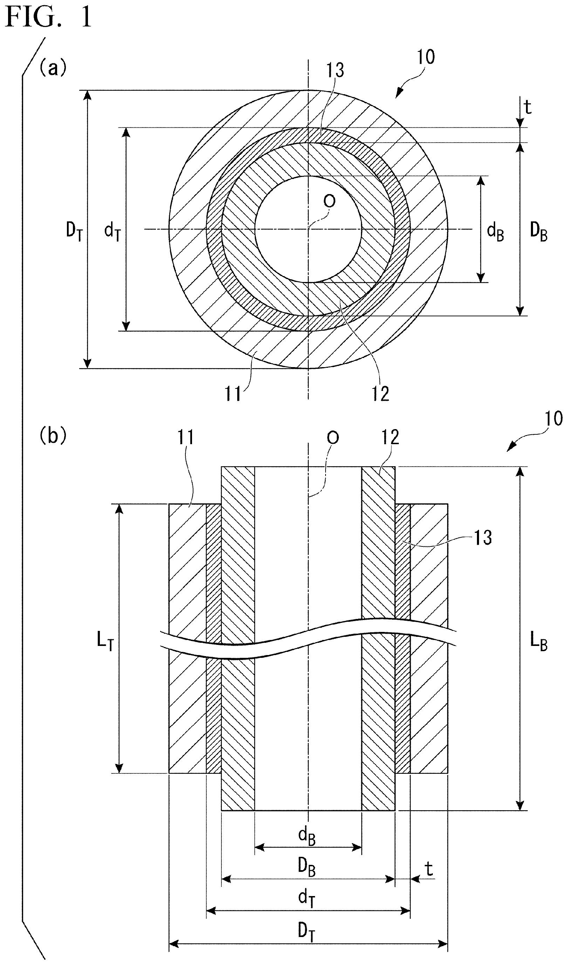

As shown in FIG. 1, a cylindrical sputtering target 10 according to the embodiment includes a sputtering target material 11 having a cylindrical shape extending along a shaft line O, and a backing tube 12 having a cylindrical shape inserted to an inner peripheral side of this sputtering target material 11.

The sputtering target material 11 and the backing tube 12 having a cylindrical shape are bonded to each other through an adhesive layer 13.

The sputtering target material 11 is configured with various metal and oxide with a composition according to a composition of a thin film to be formed, and is, for example, configured with silicon (Si), titanium (Ti), or niobium (Nb).

In addition, regarding the sputtering target material 11 having a cylindrical shape, for example, an outer diameter D_{T} is in a range of 0.15 m ≤ D_{T} ≤ 0.17 m, an inner diameter d_{T} is in a range of 0.12 m ≤ d_{T} ≤ 0.14 m, and a shaft line O direction length L_{T} is in a range of 0.5 m ≤ L_{T} ≤ 3 m.

The backing tube 12 is provided for holding the sputtering target material 11 having a cylindrical shape and ensuring mechanical strength, and has a function of supplying power to the sputtering target material 11 having a cylindrical shape and cooling the sputtering target material 11 having a cylindrical shape.

Accordingly, the backing tube 12 is necessary to have excellent mechanical strength, electric conductivity, and thermal conductivity, and is, for example, configured with stainless steel such as SUS304 or titanium.

Here, regarding the size of this backing tube 12, for example, an outer diameter D_{B} is in a range of 0.12 m ≤ D_{B} ≤ 0.14 m, an inner diameter d_{B} is in a range of 0.11 m ≤ d_{B} ≤ 0.13 m, and a shaft line O direction length L_{B} is in a range of 0.5 m ≤ L_{B} ≤ 3 m.

The adhesive layer 13 between the sputtering target material 11 having a cylindrical shape and the backing tube 12 is formed, in a case where the sputtering target material 11 having a cylindrical shape and the backing tube 12 are bonded to each other using an adhesive.

The adhesive configuring the adhesive layer 13 is configured with a solder material formed of In or In alloy. A thickness t of the adhesive layer 13 is in a range of 0.0005 m ≤ t ≤ 0.004 m.

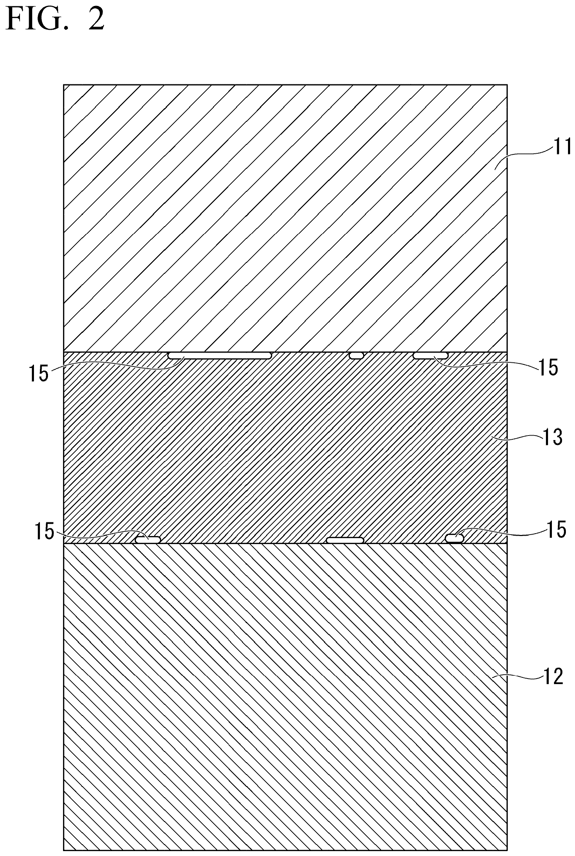

As shown in FIG. 2, in the cylindrical sputtering target 10 according to the embodiment, a maximum thickness of oxides 15 observed on a bonding interface between the sputtering target material 11 and the adhesive layer 13 and a bonding interface between the backing tube 12 and the adhesive layer 13 is equal to or smaller than 300 nm.

In the embodiment, a length of the oxide 15 having a thickness equal to or more than 150 nm observed on the bonding interface between the sputtering target material 11 and the adhesive layer 13 and the bonding interface between the backing tube 12 and the adhesive layer 13 (length along the bonding interface) is equal to or less than 1000 nm.

In the cylindrical sputtering target 10 according to the embodiment, a strength, in a case where a tensile test of the sputtering target material 11, the adhesive layer 13, and the backing tube 12 is performed in a lamination direction by using a tensile test piece cut out to have a columnar shape along a radial direction of the cylindrical sputtering target 10, that is, the lamination direction, is equal to or greater than 4 MPa.

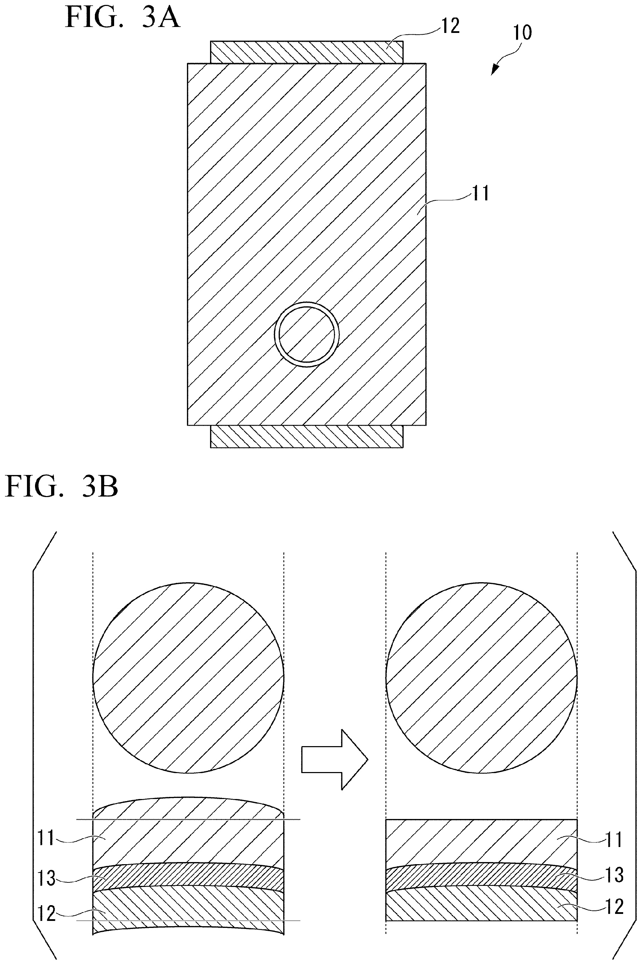

In the embodiment, as shown in FIG. 3A, a columnar sample is cut out from a side surface of the cylindrical sputtering target 10. As shown in FIG. 3B, end surfaces (outer peripheral surface and inner peripheral surface) of the sample are cut out to have a flat surface, the outer peripheral surface of the sample is cut by turning to produce a measurement sample, and a tensile strength is measured using this measurement sample. This is the bonding strength between the sputtering target material 11 and the adhesive layer 13, and between the adhesive layer 13 and the backing tube 12.

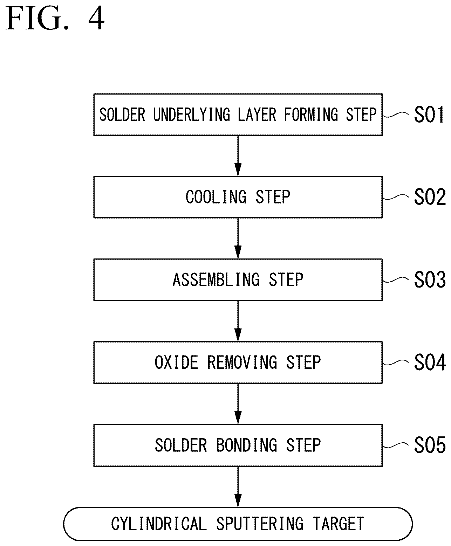

Hereinafter, a production method of the cylindrical sputtering target 10 according to the embodiment will be described with reference to FIG. 4.

### (Solder Underlying Layer Forming Step S01)

First, a melted solder material formed of In or In alloy is applied to the inner peripheral surface of the sputtering target material 11 and the outer peripheral surface of the backing tube 12, and solder underlying layers are respectively formed.

In this solder underlying layer forming step (solder material coating step) S01, the sputtering target material 11 and the backing tube 12 are heated, and the melted solder material formed of In or In alloy is applied while applying ultrasonic vibration with ultrasonic iron mounted with a heater, to form the solder underlying layers. A heating temperature in this solder underlying layer forming step S01 is 170°C to 250°C. The heating temperature is more preferably 190°C to 230°C. Here, in this solder underlying layer forming step S01, the solder underlying layers are preferably formed by a method disclosed in Japanese Unexamined Patent Application, First Publication No. 2014-037619.

### (Cooling Step S02)

Next, in a state where the solder underlying layers are formed, the cooling is temporarily performed to room temperature, in order to assemble the sputtering target material 11 and the backing tube 12.

In this cooling step S02, In oxides is generated on the surfaces of the solder underlying layers formed on the inner peripheral surface of the sputtering target material 11 and the outer peripheral surface of the backing tube 12.

### (Assembling Step S03)

Next, the sputtering target material 11 and the backing tube 12, on which the solder underlying layers are formed, are positioned and assembled. In this case, a gap having a predetermined dimension is formed between the inner peripheral surface of the sputtering target material 11 and the outer peripheral surface of the backing tube 12 by using a spacer or the like. In this assembling step S03, the sputtering target material 11 and the backing tube 12 are preferably assembled by a method disclosed in Japanese Unexamined Patent Application, First Publication No. 2014-037619.

### (Oxide Removing Step S04)

Next, the oxide generated on the surfaces of the solder underlying layers formed on the inner peripheral surface of the sputtering target material 11 and the outer peripheral surface of the backing tube 12 are removed.

In the embodiment, in a state where the sputtering target material 11 and the backing tube 12, on which the solder underlying layers are formed, are assembled, the oxides generated on the surfaces of the solder underlying layers are removed by the heating treatment under a reducing atmosphere.

In this oxide removing step S04, as the reducing atmosphere, for example, a hydrogen gas atmosphere, a CO gas atmosphere, a NH₃ decomposition gas atmosphere, or a mixed gas atmosphere thereof can be applied. In the embodiment, the hydrogen gas atmosphere is used.

In addition, heating conditions in the oxide removing step S04 is preferably suitably set in accordance with materials of the sputtering target material 11, the backing tube 12, and the adhesive layer 13. In the embodiment, a heating temperature is set to 200°C to 350°C, and a holding time at this heating temperature is set to 60 minutes to 240 minutes. The heating temperature is more preferably set to 250°C to 300°C, and the holding time is more preferably set to 90 minutes to 170 minutes.

### (Solder Bonding Step S05)

Next, after the oxide removing step S04, the melted solder material flows into a gap between the inner peripheral surface of the sputtering target material 11 and the outer peripheral surface of the backing tube 12 which are assembled, and the sputtering target material 11 and the backing tube 12 are solder-bonded to each other.

In this solder bonding step S05, subsequent to the oxide removing step S04, the solder bonding is preferably performed in the reducing atmosphere or an inert gas atmosphere such as N₂ gas or Ar gas. In addition, the heating conditions in this solder bonding step S05 are preferably suitably set in accordance with the material of the adhesive layer 13. In the embodiment, a heating temperature is set to 170°C to 250°C, and a holding time at this heating temperature is set to 10 minutes to 120 minutes. The heating temperature is more preferably set to 190°C to 230°C, and the holding time is more preferably set to 30 minutes to 90 minutes.

In this solder bonding step S05, the solder material preferably flows into the gap between the sputtering target material 11 and the backing tube 12 by a method disclosed in Japanese Unexamined Patent Application, First Publication No. 2014-037619.

According to the production method for the cylindrical sputtering target 10 according to the embodiment having such a configuration, the In oxide is generated on the surface of the solder underlying layer in the cooling step S02, and the oxide removing step S04 of removing the oxide generated on the surface of the solder underlying layer is provided after the cooling step S02, and accordingly, it is possible to prevent aggregation of the oxide generated on the surface of the solder underlying layer on the bonding interface between the sputtering target material 11 and the adhesive layer 13 and the bonding interface between the adhesive layer 13 and the backing tube 12, and it is possible to reduce the thickness of the oxides 15 formed on the bonding interface between the sputtering target material 11 and the adhesive layer 13 and the bonding interface between the adhesive layer 13 and the backing tube 12.

Therefore, it is possible to produce the cylindrical sputtering target 10 having excellent bonding strength between the sputtering target material 11 and the adhesive layer 13 and between the adhesive layer 13 and the backing tube 12 and excellent heat release properties.

In the embodiment, in the oxide removing step S04, the oxide generated on the solder underlying layer is removed by the heating treatment of the sputtering target material 11 and the backing tube 12 on which the solder underlying layer is formed, under the reducing atmosphere, and accordingly, it is possible to reduce and remove the oxide generated on the solder underlying layer. In addition, the oxide present on the inner portion of the solder underlying layer, the interface of the solder underlying layer on the sputtering target material 11 side, the interface of the solder underlying layer on the backing tube 12 side, and the like, can be removed by a reduction treatment.

In the embodiment, the assembling step S03 of assembling the sputtering target material 11 and the backing tube 12 is provided before the oxide removing step S04, and the solder bonding step S05 is performed after the oxide removing step S04, and accordingly, it is not necessary to perform re-heat in the solder bonding step S05, and it is possible to efficiently produce the cylindrical sputtering target 10.

According to the cylindrical sputtering target 10 according to the embodiment, the maximum thickness of the oxide 15 on the bonding interface between the sputtering target material 11 and the adhesive layer 13 and the bonding interface between the backing tube 12 and the adhesive layer 13 suppressed to be equal to or smaller than 300 nm, and accordingly, it is possible to improve the bonding strength between the sputtering target material 11 and the adhesive layer 13, and between the backing tube 12 and the adhesive layer 13. The maximum thickness of the oxide 15 is more preferably equal to or smaller than 250 nm and even more preferably 50 nm to 220 nm.

In addition, the sputtering target material 11 and the adhesive layer 13, and the backing tube 12 and the adhesive layer 13 are reliably bonded to each other, and accordingly, during the sputtering film formation, the heat generated on the sputtering target material 11 can be efficiently transmitted to the backing tube 12 side, and heat release properties are excellent.

Therefore, during the sputtering film formation, it is possible to prevent occurrence of cracks on the sputtering target material 11 or melting of the adhesive layer 13 and to stably perform the sputtering film formation.

In the embodiment, the length of the oxide 15 having a thickness equal to or more than 150 nm, on the bonding interface between the sputtering target material 11 and the adhesive layer 13 and the bonding interface between the backing tube 12 and the adhesive layer 13 is suppressed to be equal to or less than 1000 nm, and accordingly, it is possible to improve the bonding strength between the sputtering target material 11 and the adhesive layer 13, and between the backing tube 12 and the adhesive layer 13, and the heat release properties are excellent. The length of the oxide 15 having a thickness equal to or more than 150 nm is more preferably equal to or smaller than 710 nm and even more preferably 50 nm to 460 nm.

In the embodiment, the strength, in a case where a tensile test of the sputtering target material 11, the adhesive layer 13, and the backing tube 12 is performed in a lamination direction, is equal to or greater than 4 MPa, and accordingly, the sputtering target material 11 and the adhesive layer 13, and the backing tube 12 and the adhesive layer 13 are respectively rigidly bonded to each other, and the heat release properties are excellent. The strength, in a case where the tensile test, is performed is more preferably equal to or greater than 5 MPa and even more preferably 6 MPa to 20 MPa.

Hereinabove, the embodiments of the invention have been described, but the invention is not limited thereto, and modifications can be suitably performed within a range not departing from technical ideas of the invention.

In the embodiment, the cylindrical sputtering target shown in FIG. 1 has been described as an example, but there is no limitation thereto, as long as it is a cylindrical sputtering target including a sputtering target material having a cylindrical shape, and a backing tube bonded to an inner peripheral side of the sputtering target material having a cylindrical shape through an adhesive layer.

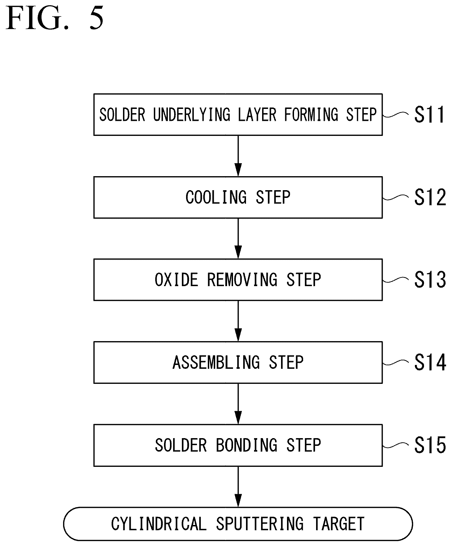

In the embodiment, as shown in FIG. 4, the oxide removing step S04 is described to be performed after the assembling step S03, but there is no limitation thereto, and as shown in FIG. 5, an oxide removing step S13 may be performed subsequent to a cooling step S12, and an assembling step S14 may be performed after the oxide removing step S13. That is, the oxide generated on the surface of the solder underlying layer is removed by the heating treatment of the sputtering target material 11 and the backing tube 12, on which the solder underlying layer is formed, under the reducing atmosphere, cooled again, and supplied to the assembling step S14. The sputtering target material 11 and the backing tube 12 are solder-bonded to each other in a solder bonding step S15, by the heating treatment after the assembling step S14. The atmosphere of the heating treatment in the solder bonding step S15 may be an air atmosphere, preferably an inert gas atmosphere, for example, a nitrogen gas atmosphere or an argon gas atmosphere.

In the embodiment, the oxide removing step has been described to be configured to reduce and remove the oxide on the surface of the solder underlying layer by the heating treatment under the reducing atmosphere, but there is no limitation thereto.

The oxide on the surface of the solder underlying layer may be chemically removed by using a chemical solution, or the oxide on the surface of the solder underlying layer may be physically removed by machining such as cutting. In a case of performing the oxide removing step having such configurations, as shown in FIG. 5, the assembling step S14 of positioning and assembling the sputtering target material and the backing tube is preferably performed after the oxide removing step S13.

### EXAMPLES

Hereinafter, results of confirmation test performed for confirming operation results of the production method of a cylindrical sputtering target and the cylindrical sputtering target according to the embodiment will be described.

A sputtering target material, a backing tube, and a solder material shown in Table 1 were prepared.

Regarding the size of the sputtering target material, an outer diameter D_{T} was set to 0.162 m, an inner diameter d_{T} was set to 0.135 m, and a shaft line direction length L_{T} was set to 0.60 m.

Regarding the size of the backing tube, an outer diameter D_{B} was set to 0.135 m, an inner diameter d_{B} was set to 0.133 m, and a shaft line direction length L_{B} was set to 0.62 m.

A melted solder material shown in Table 1 was applied to an inner peripheral surface of the sputtering target material and an outer peripheral surface of the backing tube using an ultrasonic iron, and solder underlying layers were respectively formed. A heating temperature at this time was set to 180°C.

After cooling the sputtering target material and the backing tube, on which the solder underlying layer is formed, to room temperature, in present invention examples, an oxide removing step of removing the oxide on the surface of the solder underlying layer was performed by means shown in Table 1. In comparative examples, the oxide removing step was not performed.

In the "reduction treatment" of Table 1, the heating treatment of holding the temperature at 200°C for 180 minutes under the H₂ atmosphere was performed, and the oxide was reduced and removed.

In the "chemical solution" of Table 1, the surface of the solder underlying layer was wiped with an unwoven fabric impregnated with formic acid, and then washed with acetone, to chemically remove the oxide.

In the "machining" of Table 1, the surface of the solder underlying layer was cut using a scraper made of metal and the oxide was physically removed.

The sputtering target material and the backing tube were positioned and assembled, the solder material shown in Table 1 was caused to flow into the gap between the sputtering target material and the backing tube, the sputtering target material and the backing tube were solder-bonded to each other by a method disclosed in Japanese Unexamined Patent Application, First Publication No. 2014-037619, and a cylindrical sputtering target was produced.

Regarding the obtained cylindrical sputtering target, the evaluation was performed with the following criteria.

### (Oxide)

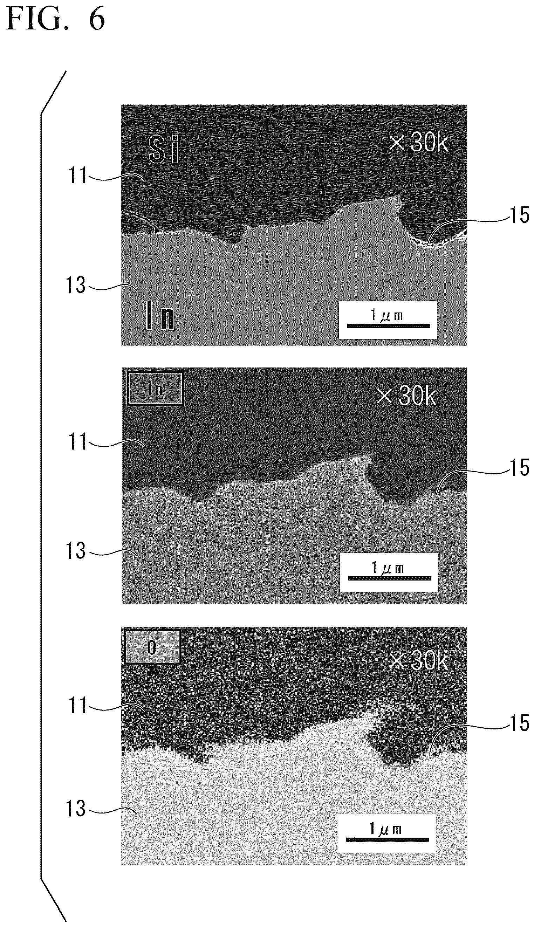

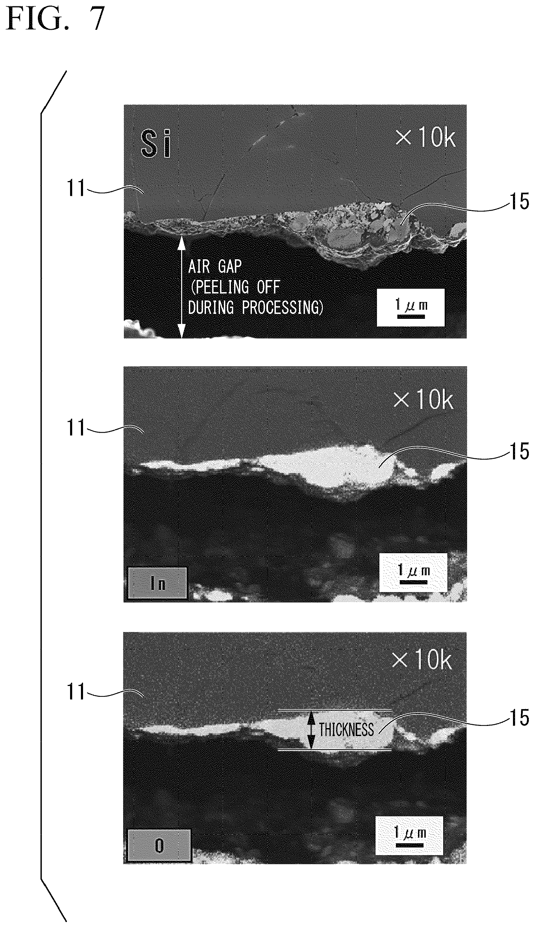

In the cross section passing the shaft line of the cylindrical sputtering target, a bonding interface between the sputtering target material and the adhesive layer and a bonding interface between the adhesive layer and the backing tube were observed, the oxide was specified by element mapping of EPMA, and a maximum thickness of the oxide, and a maximum length of the oxide having a thickness equal to or more than 150 nm were measured. The evaluation results are shown in Table 1. In addition, FIG. 6 shows an observation result of the bonding interface between the sputtering target material and the adhesive layer of Present Invention Example 2, and FIG. 7 shows an observation result of the bonding interface between the sputtering target material and the adhesive layer of Comparative Example 1.

### (Bonding Strength)

As shown in FIG. 3A, a sample having a columnar shape was cut out from a side surface of the obtained cylindrical sputtering target using a wire cutter. End surfaces (outer peripheral surface and inner peripheral surface) of this sample were cut out to have a flat surface, as shown in FIG. 3B, and the outer peripheral surface of the sample was cut to obtain a tensile test piece having a diameter of φ 20 mm. Hits tensile test piece was attached to a tensile tester INSTORON 5984 (manufactured by Illinois Tool Works Inc.) to measure the tensile strength. A maximum load was set to 150 kN and a displacement velocity was 0.1 mm/min. The measured tensile strength is shown in Table 1 as the bonding strength.

### (Sputtering Test)

The sputtering film formation was performed under the conditions shown in Table 2 for 8 hours, and the melting of the adhesive layer was evaluated.

A state where there was no melting of the adhesive layer contacted with the entire end surface of the sputtering target material having a cylindrical shape was evaluated as "A", a state where the number of portions of the melting of the adhesive layer by less than 1 mm in a shaft line direction was 2 or less over the entire end surface of the sputtering target material having a cylindrical shape was evaluated as "B", a state where the number of portions of the melting of the adhesive layer by less than 1 mm in a shaft line direction was 3 or more or portions of the melting of the adhesive layer by 1 mm or more were confirmed over the entire end surface of the sputtering target material having a cylindrical shape was evaluated as "C", and a state where the shift of the sputtering target material was confirmed was evaluated as "D". The evaluation results are shown in Table 2.

**[Table 1]**

| | | Target configuration | | | Oxide removing step | Maximum thickness of oxide (nm) | Maximum length of oxide having thickness of equal to or more than 150 nm (nm) | Bonding strength (MPa) |
|---|---|---|---|---|---|---|---|---|
| | | Target | Solder material (adhesive layer) | Backing tube | | | | |
| Present invention examples | 1 | Si | In | Ti | Reduction treatment | 250 | 350 | 5 |
| | 2 | Si | In | Ti | Machining | 190 | 250 | 6 |
| | 3 | Si | In | Ti | Chemical solution | 280 | 460 | 4 |
| | 4 | Si | In | SUS | Reduction treatment | 270 | 320 | 5 |
| | 5 | Si | In | SUS | Machining | 220 | 370 | 5 |
| | 6 | Si | In | SUS | Chemical solution | 250 | 650 | 4 |
| | 7 | Si | In-10mass%Sn | Ti | Reduction treatment | 220 | 430 | 5 |
| | 8 | Si | In-10mass%Sn | Ti | Machining | 280 | 460 | 5 |
| | 9 | Si | In-10mass%Sn | Ti | Chemical solution | 250 | 440 | 5 |
| | 10 | Al | In | SUS | Reduction treatment | 260 | 250 | 6 |
| | 11 | Al | Sn | SUS | Machining | 250 | 350 | 4 |
| | 12 | Al | In | SUS | Chemical solution | 290 | 430 | 4 |
| | 13 | Al | In | Ti | Reduction treatment | 260 | 370 | 6 |
| | 14 | Al | In | Ti | Machining | 180 | 540 | 4 |
| | 15 | Al | In | Ti | Chemical solution | 280 | 710 | 4 |
| | 16 | Nb | In | SUS | Reduction treatment | 260 | 320 | 5 |
| | 17 | Nb | In | SUS | Machining | 210 | 360 | 5 |
| | 18 | Nb | In | SUS | Chemical solution | 260 | 560 | 4 |
| Comparative examples | 1 | Si | In | Ti | None | 1550 | 5420 | 1 |
| | 2 | Si | In | SUS | None | 2120 | 3540 | 2 |
| | 3 | Si | In-10mass%Sn | Ti | None | 1430 | 3160 | 2 |
| | 4 | Al | In | SUS | None | 1540 | 5160 | 2 |
| | 5 | Al | In | Ti | None | 2470 | 2190 | 1 |
| | 6 | Nb | In | SUS | None | 1980 | 4830 | 1 |

**[Table 2]**

| | | Sputtering conditions | | | | | Evaluation results after sputtering test |
|---|---|---|---|---|---|---|---|
| | | Pressure (Pa) | Output (kW) | Rotation rate (rpm) | Output density (kW/m) | Cooling water flow rate (1/min) | |
| Present invention examples | 1 | 0.9 | 12 | 10 | 20 | 10 | A |
| | 2 | 0.9 | 12 | 10 | 20 | 10 | A |
| | 3 | 0.9 | 12 | 10 | 20 | 10 | B |
| | 4 | 0.9 | 12 | 10 | 20 | 10 | A |
| | 5 | 0.9 | 12 | 10 | 20 | 10 | A |
| | 6 | 0.9 | 12 | 10 | 20 | 10 | A |
| | 7 | 0.9 | 12 | 10 | 20 | 10 | B |
| | 8 | 0.9 | 12 | 10 | 20 | 10 | A |
| | 9 | 0.9 | 12 | 10 | 20 | 10 | A |
| | 10 | 0.9 | 12 | 10 | 20 | 10 | A |
| | 11 | 1.2 | 12 | 10 | 20 | 30 | A |
| | 12 | 1.2 | 12 | 10 | 20 | 30 | A |
| | 13 | 1.2 | 12 | 10 | 20 | 30 | A |
| | 14 | 1.2 | 12 | 10 | 20 | 30 | A |
| | 15 | 1.2 | 12 | 10 | 20 | 30 | B |
| | 16 | 0.9 | 12 | 10 | 20 | 10 | B |
| | 17 | 0.9 | 12 | 10 | 20 | 10 | A |
| | 18 | 0.9 | 12 | 10 | 20 | 10 | A |
| Comparative examples | 1 | 0.9 | 12 | 10 | 20 | 10 | C |
| | 2 | 0.9 | 12 | 10 | 20 | 10 | C |
| | 3 | 0.9 | 12 | 10 | 20 | 10 | C |
| | 4 | 1.2 | 12 | 10 | 20 | 30 | C |
| | 5 | 1.2 | 12 | 10 | 20 | 30 | D |
| | 6 | 0.9 | 12 | 10 | 20 | 10 | C |

In Comparative Examples 1 to 6 in which the oxide removing step was not performed, the maximum thickness of the oxide on both of the bonding interface between the sputtering target material and the adhesive layer and the bonding interface between the adhesive layer and the backing tube was increased, and the maximum length of the oxide having a thickness equal to or more than 150 nm was also increased. As shown in FIG. 7, in Comparative Example 1, it was confirmed that the oxide 15 is formed to be thick on the bonding interface between the sputtering target material 11 and the adhesive layer 13.

It was surmised that, during the solder bonding, the oxide generated on the surface of the solder underlying layer was aggregated on the bonding interface between the sputtering target material and the adhesive layer and the bonding interface between the adhesive layer and the backing tube, and accordingly, the oxide was formed to be thick.

In Comparative Examples 1 to 6, the bonding strength was decreased to be equal to or smaller than 2 MPa and the bonding strength was not sufficient. In addition, after the sputtering test, the melting of the adhesive layer occurred, and particularly, in Comparative Example 5, the position shift of the sputtering target material also occurred. It is surmised that this is because the heat release properties were not sufficient.

On the other hand, in Present Invention Examples 1 to 18 in which the oxide generated on the surface of the solder underlying layer was removed, the maximum thickness of the oxide on both of the bonding interface between the sputtering target material and the adhesive layer and the bonding interface between the adhesive layer and the backing tube was equal to or smaller than 300 nm, and the maximum length of the oxide having a thickness equal to or more than 150 nm was suppressed to be equal to or less than 1000 nm. As shown in FIG. 6, in Present Invention Example 2, it was confirmed that the oxide 15 formed on the bonding interface between the sputtering target material 11 and the adhesive layer 13 was thinned.

In Present Invention Examples 1 to 18, all of the bonding strength was increased to be equal to or greater than 4 MPa and the bonding strength was increased. In addition, after the sputtering test, significant melting of the adhesive layer did not occur and the heat release properties were excellent.

From the above description, according to the present invention examples, it was confirmed that it is possible to provide a production method for a cylindrical sputtering target capable of producing a cylindrical sputtering target having excellent bonding strength of a bonding interface between a sputtering target material and an adhesive layer and a bonding interface between the adhesive layer and a backing tube, and excellent heat release properties, and a cylindrical sputtering target.

### Industrial Applicability

According to the production method of the invention, it is possible to produce a cylindrical sputtering target having excellent bonding strength of a bonding interface between a sputtering target material and an adhesive layer and a bonding interface between the adhesive layer and a backing tube, and excellent heat release properties.

### Reference Signs List

10: cylindrical sputtering target
11: sputtering target material
12: backing tube
13: adhesive layer
15: oxide

## Claims

1. A production method for a cylindrical sputtering target that includes a sputtering target material having a cylindrical shape, and a backing tube that is bonded to an inner peripheral side of the sputtering target material through an adhesive layer formed of In or In alloy, the method comprising:
a solder material coating step of heating the sputtering target material and the backing tube, and applying a melted solder material formed of In or In alloy to an inner peripheral surface of the sputtering target material and an outer peripheral surface of the backing tube, to form a solder underlying layer;
a cooling step of cooling the sputtering target material and the backing tube, after the solder material coating step;
an oxide removing step of removing the oxide generated on a surface of the solder underlying layer, after the cooling step; and
a solder bonding step of solder-bonding the sputtering target material and the backing tube to each other by using a solder material formed of In or In alloy, after the oxide removing step.

2. The production method for a cylindrical sputtering target according to claim 1,
wherein, in the oxide removing step, the oxide generated on the surface of the solder underlying layer is removed by performing a heating treatment of the sputtering target material and the backing tube on which the solder underlying layer is formed, under a reducing atmosphere.

3. The production method for a cylindrical sputtering target according to claim 1,
wherein, in the oxide removing step, the oxide generated on the surface of the solder underlying layer is removed by using a chemical solution.

4. The production method for a cylindrical sputtering target according to claim 1,
wherein, in the oxide removing step, the oxide generated on the surface of the solder underlying layer is removed by machining.

5. A cylindrical sputtering target comprising:
a sputtering target material having a cylindrical shape; and
a backing tube that is bonded to an inner peripheral side of the sputtering target material through an adhesive layer formed of In or In alloy,
wherein a maximum thickness of the oxide on a bonding interface between the sputtering target material and the adhesive layer and a bonding interface between the backing tube and the adhesive layer is equal to or smaller than 300 nm.

6. The cylindrical sputtering target according to claim 5,
wherein a length of the oxide having a thickness equal to or more than 150 nm, on the bonding interface between the sputtering target material and the adhesive layer and the bonding interface between the backing tube and the adhesive layer is equal to or less than 1000 nm.

7. The cylindrical sputtering target according to claim 5 or 6,
wherein a strength, in a case where a tensile test of the sputtering target material, the adhesive layer, and the backing tube is performed in a lamination direction, is equal to or greater than 4 MPa.
